Europäisches Patentamt

European Patent Office

Office européen des brevets

(11) Publication number: **0 082 224**
**B1**

(12) **EUROPEAN PATENT SPECIFICATION**

(45) Date of publication of patent specification: **16.04.86**

(21) Application number: **81306038.1**

(22) Date of filing: **22.12.81**

(51) Int. Cl.⁴: **H 01 L 23/28**

(54) **Semiconductor device passivated with glass material.**

(43) Date of publication of application:
**29.06.83 Bulletin 83/26**

(45) Publication of the grant of the patent:
**16.04.86 Bulletin 86/16**

(84) Designated Contracting States:
**DE FR GB NL**

(56) References cited:
**GB-A-2 009 505**
**GB-A-2 047 461**

**PATENTS ABSTRACTS OF JAPAN, vol. 3, no. 36(E-100), 27th March 1979, page 118E100**

(73) Proprietor: **Hitachi, Ltd.**
**5-1, Marunouchi 1-chome**
**Chiyoda-ku Tokyo 100 (JP)**

(72) Inventor: **Misawa, Yutaka**
**818-6 Nishihara Tabiko**
**Katsuta-shi (JP)**
Inventor: **Takahashi, Masaaki**
**8-14 Kujicho-5-chome**
**Hitachi-shi (JP)**
Inventor: **Hachino, Hiroaki**
**26-18 Moriyamacho-2-chome**
**Hitachi-shi (JP)**

(74) Representative: **Paget, Hugh Charles Edward et al**
**MEWBURN ELLIS & CO. 2/3 Cursitor Street**
**London EC4A 1BQ (GB)**

**The file contains technical information submitted after the application was filed and not included in this specification**

Courier Press, Leamington Spa, England.

## Description

The present invention relates to a semiconductor device in which an exposed surface of a semiconductor substrate, to which at least one pn junction is exposed, is passivated with glass material, and more particularly to a semiconductor device in which at least one pn junction is exposed in a moat provided in a semiconductor substrate, and the surface of the groove or moat including the exposed end of the pn junction is passivated with glass material.

In semiconductor devices for rectifying or controlling a current flow such as a diode, a transistor or a thyristor, a surface part of a semiconductor substrate, to which a pn junction formed in the semiconductor substrate is exposed, is protected with an insulating material, namely, a dielectric material. Otherwise, harmful substances from the outside of the semiconductor device, for example, ions of an alkali metal, water (moisture), or dust, may exert an undesirable influence upon the above surface part, to deteriorate the electric characteristics of the semiconductor device (for example, reverse blocking characteristics and/or leakage characteristics).

Oxide or nitride of silicon, oxide of a metal, resin, and others have hitherto been used as the above-mentioned insulating material.

In recent years, attention has been attracted to preparing glass in the powder state and firing it on a semiconductor substrate for the same purpose as mentioned above. Glass can form a thick film as compared with conventional insulating inorganic materials, is not readily subjected to influence from the outside, and can form a dense film. Also, a glass film has a high permeation-preventing effect for gas and liquid, as compared with an organic material film.

Glass materials suitable for use in passivation for semiconductor devices include, for example, zinc borosilicate glass which contains ZnO as one of the main components, lead borosilicate glass and lead aluminosilicate glass both of which contain PbO and $SiO_2$ as two of the main components.

A semiconductor device using glass as passivation material is preferably provided with a groove or moat in one major surface of a semiconductor substrate, and a terminal end of a pn junction to be passivated with glass is exposed to the surface of the groove or moat. Glass is applied in the groove or moat and is then fired to passivate the exposed end of the pn junction with glass. Such a structure advantageously enhances the blocking voltage of the device, and moreover makes it easy to fabricate the semiconductor device. A semiconductor device having such a structure is hereinafter referred to as a moat type semiconductor device.

An example of a moat type semiconductor device using glass as the passivation material is disclosed in JP—A—54—14677. This document shows a semiconductor device having: two semiconductor regions of opposite conductivity type in a semiconductor substrate, the two semiconductor regions defining a pn junction (J);

a moat in the form of a closed loop in at least one major surface of the substrate such that the pn junction (J) terminates at an inner inclined surface of the moat, a first one of the semiconductor regions extending below the moat;

fired glass in the moat for passivating an exposed end portion of the pn junction (J); and

at least two electrodes on major surfaces of the substrate for permitting a reverse bias voltage to be applied to the pn junction (J).

Furthermore this device has a channel stopper region in the substrate adjacent and outside the moat, the channel stopper region being of the same conductivity type as the first one of the semiconductor regions but higher in impurity concentration than that region. Thus this device corresponds to the pre-characterising part of claim 1.

With this structure, even when the characteristic of an interface between glass and the semiconductor substrate varies, any adverse effect due to such a variation can be prevented by the channel stopper region, and therefore the high blocking voltage characteristic and high reliability is obtained. However, JP—A—54—14677 does not discuss the characteristics of glass used for passivation.

However, detailed experiments made by the present inventors have revealed that even a moat type semiconductor device provided with a channel stopper region may not provide a sufficiently high blocking voltage. In recent years electronic apparatuses have been in the form of solid state circuits, and therefore a semiconductor device having a blocking voltage of about 1200 V or more is desirable so as to control or rectify a current under a high applied voltage in the electronic apparatuses. For example, a horizontal deflection circuit incorporated in a television receiver set requires a transistor having a blocking voltage higher than 1500 V, and a converter for 220 V line requires a gate turn off thyristor having a blocking voltage of at least 1200 V. It is difficult reproducibly to obtain a high blocking voltage of 1200 V or more with conventional moat type semiconductor devices.

Therefore the present invention proposes that the fired glass has electric charges of a polarity for inducing charges of a polarity opposite to the conductivity type of the first one of the semiconductor regions in a part of that region in contact with the moat.

Thus, when the semiconductor region which is contiguous to the bottom of the groove or moat, is an n-type region, the surface of the glass has negative charge, which induces positive charge in the part of the substrate contiguous to the groove or moat. The glass preferably has a negative surface charge density within a range from $-3\times10^{11}cm^{-2}$ to $-9\times10^{11}cm^{-2}$, where the minus sign indicates the negative polarity of the surface charge.

Experiments made by the present inventors have revealed that, in moat type semiconductor devices each provided with a highly-doped channel stopper region, the blocking voltage of the above-mentioned pn junction depends upon the angle between a slope of the inner side surface of the moat and a pn junction plane terminating at the slope substended by a more heavily doped one of the pn junction-forming regions, and upon a surface charge density of glass which fills the moat. When the slope of the moat makes an acute angle with the pn junction plane in the more heavily doped one of the semiconductor regions for forming the pn junction (as conventionally referred to that the slope and the pn junction plane form a negative bevel), the blocking voltage of the pn junction can be improved by coating the moat with glass having negative surface charge in the case where an n-type semiconductor region is contiguous to the moat.

A further investigation made by the present inventors has revealed that when glass having positive surface charge is provided in the moat of a semiconductor device having the above-mentioned negative bevel structure, it is easier to break down the pn junction in the bulk of the semiconductor substrate. It was also found that the field strength in the channel stopper region provided at the outer periphery of the moat is increased causing easier breakdown when a surface charge, even though negative, exceeds $9 \times 10^{11}/cm^2$, and that the negative surface charge is most preferably in a range from $3 \times 10^{11}/cm^2$ to $9 \times 10^{11}/cm^2$ for preventing easy breakdown of a pn junction and for reproducibly providing a high blocking voltage of the pn junction.

It was also found that the characteristics of the glass-semiconductor interface is also influenced to some extent by the orientation of semiconductor surface and that the blocking voltage is little influenced by the thickness of the glass layer in case when the thickness is not less than about 15 μm.

Furthermore, according to the present invention the depth of the channel stopper region from the major surface of the substrate is greater than the depth of the pn junction (J) from that major surface. This feature gives the device a high breakdown voltage, because when the pn junction is reverse biassed the depletion layer extends into the first one of the semiconductor regions. The excess depth of the channel stopper region prevents the concentration of electric field, and so prevents early breakdown, even when a high reverse bias is applied. The greater thickness of the channel stopper region also make the device easier to fabricate, as will be discussed later. In JP—A—54—14677, however, the thickness of the channel stopper region is less than the depth of the pn junction.

Embodiments of the invention will now be described in detail, by way of example, with reference to the accompanying drawings, in which:

Fig. 1A is a perspective view showing a chip of a gate turn off thyristor, being a first enbodiment of the present invention,

Fig. 1B is a view taken along the line IB—IB' in Fig. 1A,

Fig. 2 is a graph showing the relationship between the surface charge density $N_{FB}$ of the glass applied to the moat and the forward blocking voltage applied between the anode and cathode in the thyristor of Fig. 1,

Fig. 3A is a perspective view showing a reverse blocking thyristor chip of corner gate type according to a second embodiment of the present invention,

Fig. 3B is a view showing part of the cross section taken along the line IIIB—IIIB' in Fig. 3A.

Fig. 4A is a perspective view showing a reverse blocking thyristor chip of centre gate type according to a third embodiment of the present invention,

Fig. 4B is a view showing part of the cross section taken along a line intersecting the centre of one major surface in Fig. 4A,

Fig. 5 is a three-component composition diagram for showing a vitrifiable range of ZnO—$B_2O_3$—$SiO_2$ glass applicable to the present invention,

Fig. 6A and 6B are three-component composition diagrams showing the relationship between the composition of glass containing ZnO, $B_2O_3$ and $SiO_2$ and the surface charge density $N_{FB}$, wherein Fig. 6A shows the case where the firing temperature of glass is 630°C, and Fig. 6B shows the case where the firing temperature is 780°C.

Figs. 7A and 7B are three-component composition diagrams showing the relationship between the composition of glass containing ZnO, $B_2O_3$ and $SiO_2$ and the coefficient of thermal expansion of the above glass, wherein Fig. 7A shows the case where the firing temperature of glass is 630°C, and Fig. 7B shows the case where the firing temperature is about 780°C.

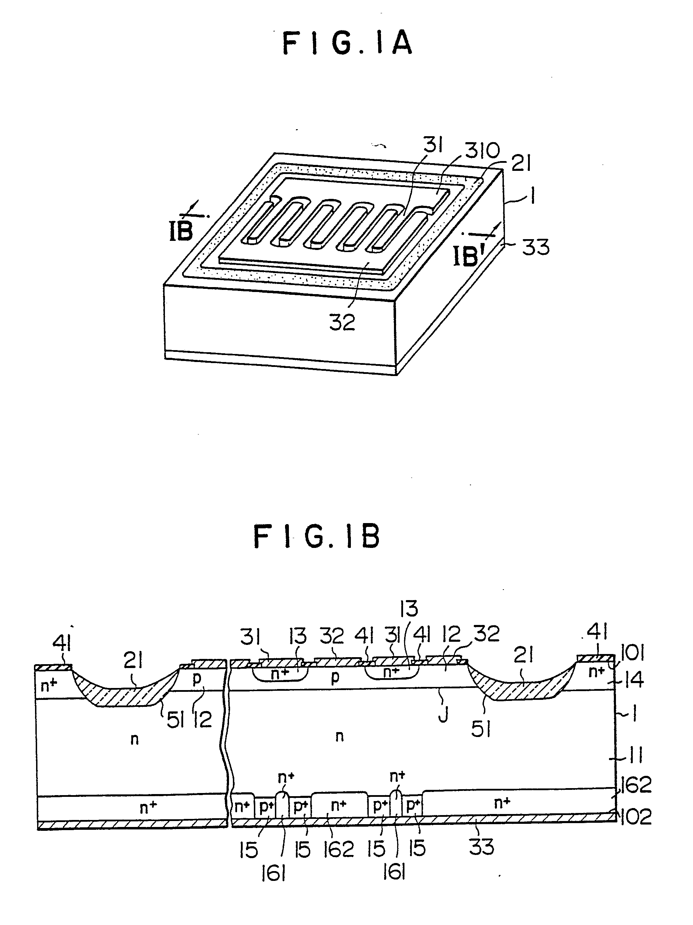

Figs. 1A and 1B show a gate turn off thyristor (hereinafter referred to as a "GTO") according to a first embodiment of the present invention. Referring to Figs. 1A and 1B, a silicon substrate 1 has a pair of major surfaces 101 and 102, and a four-layer laminate structure made up of an n-type emitter, a p-type base region 12, an n-type base region 11 and a p-type emitter region 15 is formed between the major surfaces 101 and 102. The n-type base region 11 and the p-type base region 12 form the two semiconductor regions of the present invention. The n-emitter 13 is divided into a plurality of strip regions 13. Each of the n-emitter regions 13 thus formed is exposed at one major surface 101, and a cathode electrode 31 is provided on the exposed surface of each n-emitter region. The p-base region 12 is exposed to the major surface 101 so as to surround the n-emitter regions 13, and a gate electrode 32 is provided on the exposed surface of the p-base region 12.

As shown in Fig. 1A, the cathode electrode 31 includes a common connecting region 310 for connecting in common divided electrode portions in ohmic contact with the respective n-emitter regions. The common connecting region 310 is provided above the exposed surface of the p-base region 12, with an $SiO_2$ film (not shown) interposed between the common connecting region 310 and the exposed surface of tbe p-base region 12 to insulate the common connecting region 310 from the base region 12. The p-emitter region 15 is provided in part of the other major surface 102 in approximate registry with the n-emitter regions. That is, the p-emitter region 15 is divided into a plurality of regions similar to and to oppose the divided n-emitter regions 13. A first $n^+$-type anode short region 161 penetrates each of the p-emitter regions thus formed, at central part thereof. A second $n^+$-type anode short region 162 is exposed at part of the major surface 102 other than respective exposed surfaces of the p-emitter regions and respective exposed surfaces of the first $n^+$-type anode short regions 161. An anode electrode 33 is formed over all the major surfaces 102. The first anode short regions 161 and the second anode short region 162 form a short circuit between the n-base region 11 and the anode electrode 33. Such a shorting structure is effective in improving the turn-off characteristic.

A moat 51 in the form of a closed loop is cut in the major surface 101 along the periphery thereof. The moat 51 is cut to a depth such that the bottom of the moat is within the high resistivity n-base region 11. Therefore, the pn junction formed between the p-base region 12 and the high resistivity n-base region 11 terminates at an inclined surface of the moat 51. An $n^+$-type channel stopper region 14, which has a greater thickness than the p-base region 12, is formed as a closed loop outside the moat 51. Glass material 21 having characteristics which will be explained later, is fired in the moat 51. Part of the major surface 101 other than the part provided with the electrodes is coated with an $SiO_2$ film 41 for the purpose of passivation. The field mitigating means in the present embodiment are made up of the glass material 21 and the $n^+$-type channel stopper region 14 which has a greater thickness than the p-base region 12 and is highly doped.

Such a GTO can be fabricated, for example, by impurity diffusion techniques, photolithography and selective etching techniques, using an n-type (111) silicon plate having a resistivity of about 6-$\Omega$cm as the starting material. Gallium is diffused into the high resistivity n-type silicon plate from a pair of major surfaces thereof to form the P-base region 12 and p-emitter region 15. Next, phosphorus is selectively diffused from the major surfaces into those areas corresponding to regions 14, 161 and 162. At this time, the phosphorus concentration in the diffused regions is greater than the gallium concentration in these regions, and the diffusion depth of the phosphorus is made greater than that of the gallium. Thus, the channel stopper region 14 is formed on the side of the major surface 101, and the first anode short regions 161 and second anode short region 162 are formed on the side of the major surface 102. Then, phosphorus is diffused into those areas corresponding to the n-emitter regions 13 so that the diffusion depth of the phosphorus is smaller than the depth of the p-base region 12, to form the n-emitter regions 13.

The moat 51 can be made using selective etching techniques, and the electrodes 31, 32 and 33 can be formed by depositing a metal such as chromium, nickel, silver or aluminium on predetermined areas of the silicon substrate by e.g. vacuum evaporation techniques or the like. The $SiO_2$ film 41 can be formed by thermally oxidizing the exposed surface of the silicon substrate.

Each n-emitter region 13 has a thickness of about 15 μm, and the surface of diffusion has an impurity concentration of about $10^{20}$ atoms/$cm^3$ or more. The p-base region 12 has a thickness of about 30 μm, and the surface of diffusion has an impurity concentration of about $10^{18}$ atoms/$cm^3$. The $n^+$-type channel stopper region 14 has a thickness of about 70 μm and a width of about 50 μm or more, and the surface of diffusion has an impurity concentration of about $10^{20}$ atoms/$cm^3$ or more. The n-base region 11 has a thickness of about 180 μm and a resistivity of about 60 $\Omega$cm. The moat 51 has a width of about 300 μm and a depth of about 90 μm, and therefore the depth of the moat is greater than the thickness of the channel stopper region 14 and also than that of the p-base region 12.

The glass 21 is filled in the moat 51 provided in the above-mentioned GTO. The glass 21 can be formed by suspending glass powder in a liquid, adhering the powder to the surface of the moat 51 by electrophoresis, and then firing the powder. The glass 21 obtained after firing has a thickness of 20 to 30 μm. The glass material 21 used was zinc borosilicate glass. The zinc borosilicate glass preferably contains more than about 50 percent ZnO by weight.

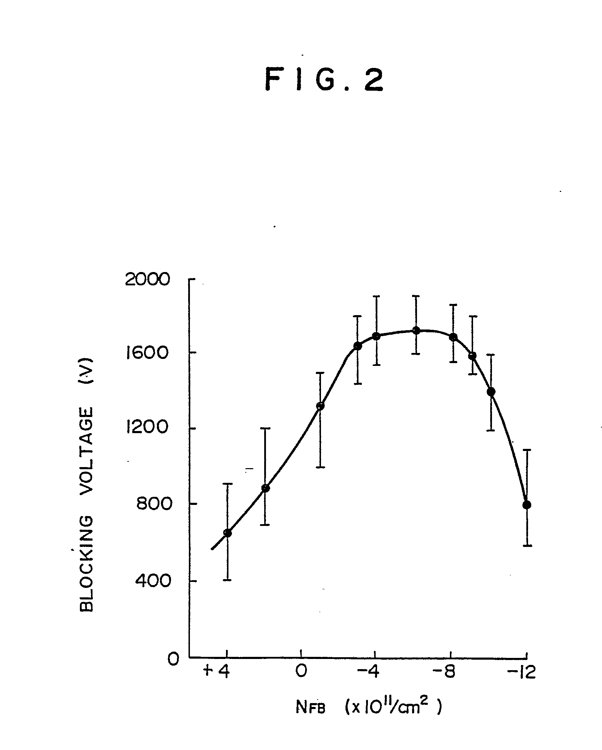

The amount of surface charge on the glass 21 can be varied by changing the composition of the glass 21, the firing temperature, firing time, firing atmosphere and the cooling rate after firing of the glass 21. Changes in the forward blocking voltage of the above-mentioned GTO (namely, changes in the blocking voltage of the pn junction formed between the p-base region 12 and the n-base region 11) were measured when the amount of charge kept by the glass 21 was varied. The results of measurements are shown in Fig. 2. The amount of charge per unit area at the surface of the glass 21 which is in contact with the inner wall of the moat 51, is expressed by $N_{FB}$ ($cm^{-2}$).

As is evident from Fig. 2, the blocking voltage is highest when the surface charge density $N_{FB}$ is within a range from $-3 \times 10^{11}$/$cm^2$ to $-9 \times 10^{11}$/$cm^2$, that is, when the negative surface charge per unit area lies within a range from $3 \times 10^{11}$/$cm^2$ to $9 \times 10^{11}$/$cm^2$. Even when the surface charge density $N_{FB}$ varies to some extent within this range, the high blocking voltage is not affected. In other words, a reproducible, high blocking voltage is obtained, even if the surface charge density $N_{FB}$ fluctuates. Accordingly, in the present embodiment, it is preferred that the glass 21 has a surface charge density $N_{FB}$ of $-3 \times 10^{11}/cm^2$ to $-9 \times 10^{11}/cm^2$.

According to experiments made by the present inventors, when zinc borosilicate glass was fired at a temperature of 680 to 740°C for about 40 minutes in an atomspere containing 1 to 100 weight percent dry $O_2$ (and the balance $N_2$), and then cooled at a rate of about 1°C/min., a value of $N_{FB}$ within the above-mentioned range was obtained. The zinc borosilicate glass had, for example, 65 percent ZnO, 21 percent $B_2O_3$, 8.5 percent $SiO_2$, 4 percent PbO, 1 percent SnO and 0.5 percent $Sb_2O_3$ by weight.

In the present invention, the depth of the $n^+$-type channel stopper region 14 is larger than that of the p-base region 12. Such a structure has the following advantages. Firstly, it is not necessary that a p-type impurity is selectively diffused into the silicon substrate 1 from the major surface 101 to form the p-base region 12. That is, when the p-type impurity is diffused to a predetermined depth from the whole of the major surface 101 and then an n-type impurity is selectively diffused into the channel stopper region 14 in such a manner that the concentration of the n-type impurity is higher than that of the p-type impurity and the diffusion depth of the n-type impurity is greater than that of the p-type impurity, the channel stopper region shown in Fig. 1B is formed. Therefore, the fabricating process can be simplified. Such a fabricating method is particularly advantageous when gallium and aluminium are diffused as the p-type impurity, since it is difficult to obtain an appropriate mask for selective diffusion of gallium and aluminium. Also, suppose that the region 14 were smaller in thickness than the region 12. In this case, it would be required to selectively form the region 12 in that part of the major surface 101 which is surrounded by the moat 51. If, in the above selective formation process, pin holes are accidentally generated in a cover for masking a portion of the major surface 101 outside the moat 51 from a diffusion source, p-type regions which are greater in depth than the region 14, are formed in the surface portion outside the moat 51, and the function of the channel stopper region is deteriorated. In other words, the effective width of the channel stopper region is reduced. Further, the yield of high breakdown voltage semiconductor devices is lowered. According to the present embodiment, all of these drawbacks may be eliminated.

Secondly, the gradient of impurity concentration at the boundary between the $n^+$-type channel stopper region 14 and the n-base region 11 becomes gentle, since the thickness of the region 14 is large. Therefore, when the pn junction exposed at the moat 51 is reversely biased, the depletion layer extends from the pn junction into the n-base region 11 and, even after it has reached the channel stopper region 14, it can be further extended gradually in the channel stopper region 14 when the reverse bias voltage is increased. Thus, even when a high reverse bias voltage is applied, concentration of the electric field is mitigated, and therefore it is possible to provide a high breakdown voltage.

The width of the channel stopper region 14 (that is, the width of the region 14 at the boundary between the region 14 and the n-base region 11 in the direction perpendicular to the lengthwise direction of the moat 51) is preferably made larger than 50 μm, in order effectively to extend the depletion layer and to make the breakdown voltage high.

The depth of the moat 51 is preferably larger than respective thicknesses of the p-base region 12 and channel stopper region 14. When the depth of the moat 51 is smaller than the thickness of the p-base region 12 so that part of the p-base region 12 is extended along the bottom of the moat 51 and the pn junction J terminates at the bottom of the moat 51, the breakdown voltage varies widely. This is because the electric field generated at one end of the pn junction J, when the pn junction J is reverse biased, depends upon the length of that portion of the p-base region which is located beneath the bottom of the moat 51 and upon the depth of the moat 51 in a critical manner, and cannot be easily controlled.

Also, the difference in depth between the bottom of the moat 51 and the bottom of the region 12 (namely, the pn junction J) is preferably made larger than 10 μm to reduce variations in the breakdown voltage. The reason for this is as follows. Compensation of impurity concentration takes place in the proximity of a pn junction, since two regions of different conductivity types are contiguous to each other at the pn junction, so that compensated regions have higher resistivity. Thus, the depletion layer can be readily extended in such regions. When the pn junction is located in the proximity of the bottom of the moat 51, the depletion layer can be easily extended to reach the bottom of the moat 51 and further extension of the depletion layer is restricted. Therefore, the blocking voltage can be lowered at a portion beneath the moat 51, and the leakage current can be increased.

When the channel stopper region is formed by diffusion, it is desirable to make time required for the formation of the channel stopper region as short as possible. Accordingly, it is preferable to make the thickness of the channel stopper region smaller than the depth of the moat 51.

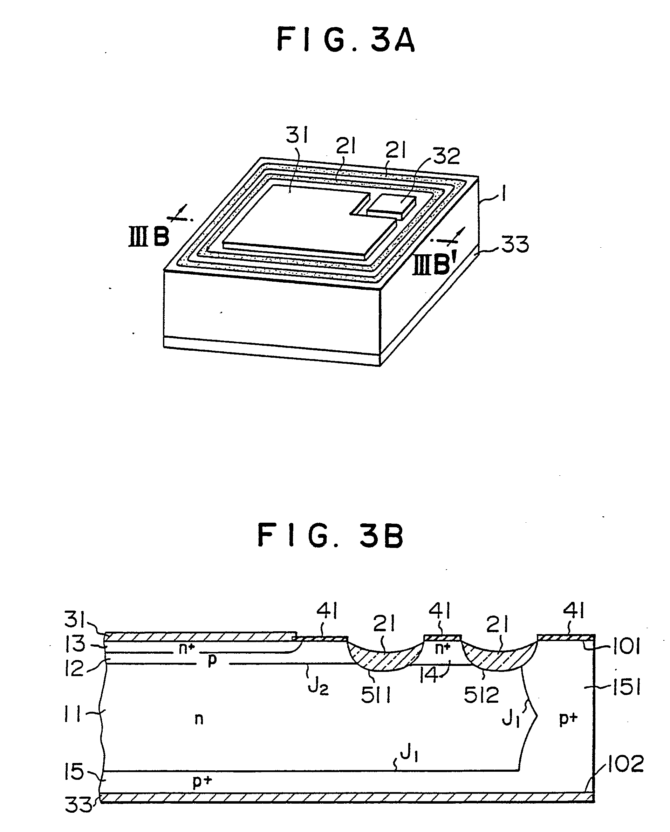

Now, a second embodiment of the present invention will be explained with reference to Figs. 3A and 3B. The second embodiment relates to a reverse blocking thyristor. Unlike the above-mentioned GTO having a shorting structure in the anode region, the reverse blocking thyristor must be able to block both forward and reverse voltages applied between anode and cathode electrodes. That is, a high blocking voltage is desired in both forward and reverse directions.

In Figs. 3A and 3B, parts similar or equivalent to those· in Figs. 1A and 1B are given the same reference numerals as in Figs. 1A and 1B.

Referring to Figs. 3A and 3B, two moats 511 and 512 are provided in one major surface 101, and the depth and width of each of the moats 511 and 512 are nearly equal to the depth and width of the moat 51 shown in Fig. 1B. The distance between the moats 511 and 512 is about 70 μm. Cathode and gate electrodes 31 and 32 are formed on that inner part of the major surface 101 which is surrounded by the inner moat 511. The gate electrode 32 is near one corner of the above-mentioned inner part, and has substantially a rectangular form. The cathode electrode 31 is insulated from the gate electrode 32, and is formed on the rest of the above inner part. Such an electrode arrangement is called a corner gate type.

Fig. 3B shows part of a cross section taken along the line IIIB—IIIB' in Fig. 3A. Referring to Fig. 3B, an n-emitter region 13, a p-base region 12, an n-base region 11 and a p-emitter region 15 are stacked in the order described, between the cathode electrode 31 and the anode electrode 32 formed on the other major surface 102. The n-base 11 region and the p-base region 12 form the two semiconductor regions of the present invention. Unlike the embodiment shown in Figs. 1A and 1B, the n-emitter region 13 is not divided into a plurality of regions, and the p-emitter region 15 has no shorting structure and is uniform in structure. A pn junction $J_1$ between the n-base region 11 and the p-emitter region 15 terminates at the outer moat 512 due to the presence of a $p^+$-type region 151 (communicating with the p-emitter region 15) which connects peripheral parts of the major surfaces 101 and 102. A pn junction $J_2$ between the p-base region 12 and the n-base region 11 terminates at the inner inclined surface of the inner moat 511, and the pn junction $J_2$ and the inner inclined surface of the moat 511 form a negative bevel structure. An $n^+$-type channel stopper region 14 is formed between the moats 511 and 512, exposed at the major surface 101, and is in the form of a closed loop. Glass material 21 having negative charge is filled in each of the moats 511 and 512. An $SiO_2$ film 41 for passivation is formed on the major surface 101 in the area other than the gate and cathode electrode areas. In the second embodiment, field mitigating means include the moats 511 and 512 filled with negatively charged glass material 21 and the channel stopper region 14.

The semiconductor element shown in Figs. 3A and 3B can be fabricated by e.g. impurity diffusion techniques, photolithography, and selective etching techniques, as for the embodiment shown in Figs. 1A and 1B. Further, the same materials as used in the embodiment shown in Fig. 1A and 1B can be used. The thickness of the region 14 is greater than that of the n-emitter region 13 as in the embodiment shown in Figs. 1A and 1B. The $p^+$-type region 151 may be formed e.g. by diffusing a p-type impurity from respective peripheral portions of the major surfaces 101 and 102 into the semiconductor substrate to a depth corresponding to more than one half of the thickness of the semiconductor substrate so that two diffused regions meet each other.

In the forward blocking state of the second embodiment, namely, when an input voltage is applied between the anode and cathode electrodes 33 and 31 such that the potential of the anode electrode 33 is positive compared with that of the cathode electrode 31, a depletion layer extends from the pn junction $J_2$ mainly into the n-base region 11. Since the glass material 21 has negative charge, the depletion layer is more easily extended along the moat 511 rather than into the bulk of the semiconductor substrate in the area away from the moat. Therefore, electric field in the region around the moat is mitigated. When the voltage applied between the anode and cathode electrodes is increased, the end of the depletion layer will reach the channel stopper region 14. Since the region 14 has a higher impurity concentration than the n-base region 11, the rate of extension of the depletion layer will be largely slowed down in the channel stopper region 14. Thus, the depletion layer is prevented from being further extended outward and from being exposed to the periphery of the semiconductor substrate. Accordingly, it is possible to maintain a high blocking voltage. The rate of extension of the depletion layer in the portion of the region 11 along the moat is determined mainly by the amount of charge kept by the glass material 21. Experiments made by the present inventors have shown that a surface charge density $N_{FB}$ of the glass material 21 is preferably in a range from $-3 \times 10^{11} cm^{-2}$ to $-9 \times 10^{11} cm^{-2}$ to provide a breakdown voltage of about 1.6 kV, which has not been obtained heretofore.

When the polarity of the voltage applied between the anode and cathode electrodes is reversed with the potential of the cathode electode being positive as compared with that of the anode electrode, the thyristor takes a reverse blocking state. At this time, a depletion layer extends from the pn junction $J_1$ mainly into the n-base region 11. In the part along the moat 512, the rate of extension of the depletion layer becomes slow in the channel stopper region 14 in accordance with the same mechanism as in the forward blocking state. Accordingly even when a higher reverse voltage is applied, the depletion layer is not extended along the moat 511 and does not reach the p-base region 12, and the blocking state is not destroyed.

It is to be noted in the second embodiment that the pn junction $J_1$ and the outer inclined surface of the moat 512 form a positive bevel structure, whereas the pn junction $J_2$ and the inner inclined surface of the moat 511 form a negative bevel structure.

In such a situation, if the channel stopper region is absent and the glass 21 has negative charge, the blocking ability in the forward blocking state is good but the blocking ability in the reverse blocking state is not so good. On the other hand, if the channel stopper region is present and the glass 21 has positive charge, the blocking ability in the reverse blocking state is good but the blocking ability in the forward blocking state is not so good. In the second embodiment, the blocking function is good in both the forward and reverse blocking states, since the channel stopper region is formed and the glass 21 has negative charge.

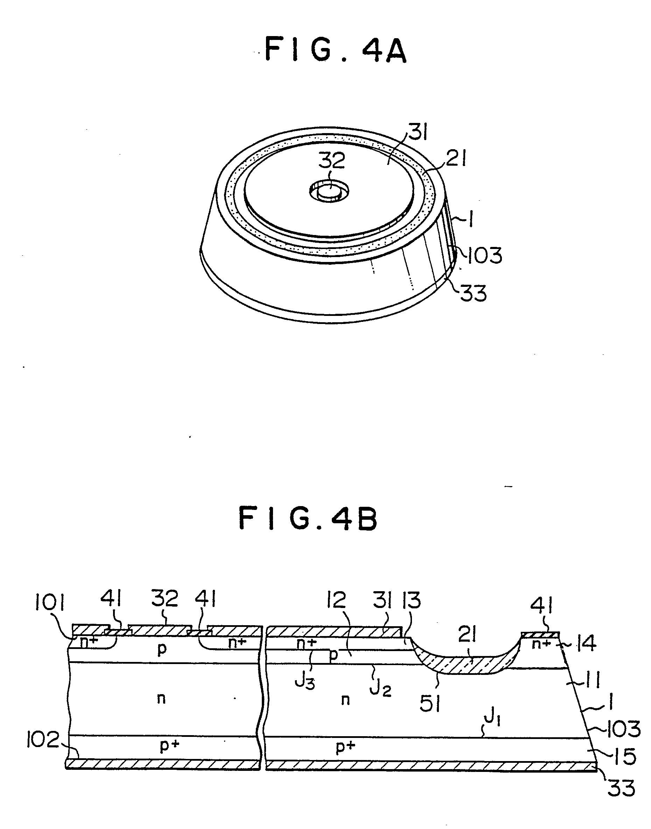

Next, a third embodiment of the present invention will be explained with reference to Figs. 4A and 4B. In the third embodiment, a semiconductor substrate 1 has a disc shape. Each major surface 101 and 102 has a circular shape, and the diameter of the major surface 101 is smaller than that of the major surface 102. The side surface 103 connecting the major surfaces 101 and 102 is not at right angles with the major surfaces 101 and 102, but is inclined to the major surfaces 101 and 102. Referring to Fig. 4A, a gate electrode 32 is formed on a central part of the major surface 101, and a cathode electrode 31 is formed on the major surface 101 so that it is insulated from and surrounds the gate electrode 32. A moat 51 in the form of a closed loop is formed around the cathode electrode 31. An anode electrode 33 is formed on the whole of the other major surface 102. The above-mentioned third embodiment is a reverse blocking thyristor having the same function as the reverse blocking thyristor shown in Figs. 3A and 3B. The thyristor of this embodiment as shown in Fig. 4A is called the reverse blocking thyristor of centre gate type, since the gate elctrode is arranged at a central portion of one major surface.

Fig. 4B shows a part of a cross section taken along a diameter of the circular plate in Fig. 4A. Referring to Fig. 4B, an n-emitter region 13, a p-base region 12, an n-base region 11 and a p-emitter region 15 are stacked beween the cathode electrode 31 and the anode electrode 33, as in Fig. 3B. The n-base region 11 and the p-base region 12 form the two semiconductor regions of the present invention. However, unlike the second embodiment shown in Fig. 3B, the p-emitter region 15 is uniform and terminates at the side surface 103 of the semiconductor substrate 1. The p-emitter region 15 has a higher impurity concentration than the n-base region 11. The side surface 103 is tapered toward the major surface 101 such that the area of a plane parallel to the major surfaces 101 and 102 is diminished in a direction from the major surface 102 to 101. Therefore, the pn junction $J_1$ which is formed between the p-emitter region 15 and the n-base region 11, and the side surface 103 form a positive bevel structure. Such a positive bevel structure acts to increase the blocking voltage of the pn junction $J_1$, as described in US—A—3491272. The pn junction $J_2$ between the p-base region 12 and the n-base region 11 terminates at the inner, inclined surface of the moat 51. The p-base region 12 has a higher impurity concentration than the n-base region 11. Therefore, the inner inclined surface of the moat 51 and the pn junction $J_2$ form

a negative bevel structure. The depth of the moat 51 is greater than the depth of the pn junction $J_2$. A pn junction $J_3$ between the n-emitter region 13 and the p-base region 12, and the pn junction $J_2$ terminate at the inner inclined surface of the moat 51. There is an $n^+$-type channel stopper region 14 between the outer inclined surface of the moat 51 and the side surface 103 to connect these surfaces with each other. The channel stopper region 14 is thicker than the n-emitter region 13. Glass material 21 which has an appropriate composition is applied in the moat 51 and fired to have negative charge.

In the semiconductor element of the third embodiment, field mitigating means include the moat 51, the glass 21 in the moat and the positive bevel structure formed by the pn junction $J_1$ and the side surface 103.

The semiconductor element shown in Figs. 4A and 4B can be fabricated in similar manner as the second embodiment shown in Figs. 3A and 3B, and therefore a detailed explanation is omitted. Further, the same materials as used in the second embodiment can be used in the third embodiment. When the thyristor of this embodiment shown in Figs. 4A and 4B takes a forward blocking state, a high blocking voltage is obtained on the basis of the same mechanism as in the embodiments shown in Figs. 1A and 3A. On the other hand, when the thyristor has a reverse blocking state (i.e., when the greater part of a voltage applied across the thyristor is applied across the pn junction $J_1$), a high breakdown voltage is obtained on the basis of the positive bevel structure at the side surface 103.

Next, explanation will be made on glass which can be used as the glass material 21 in the above-mentioned embodiments. This glass essentially consists of three main components ZnO, $B_2O_3$ and $SiO_2$. Similar glass material is disclosed in DE—A—2851479.

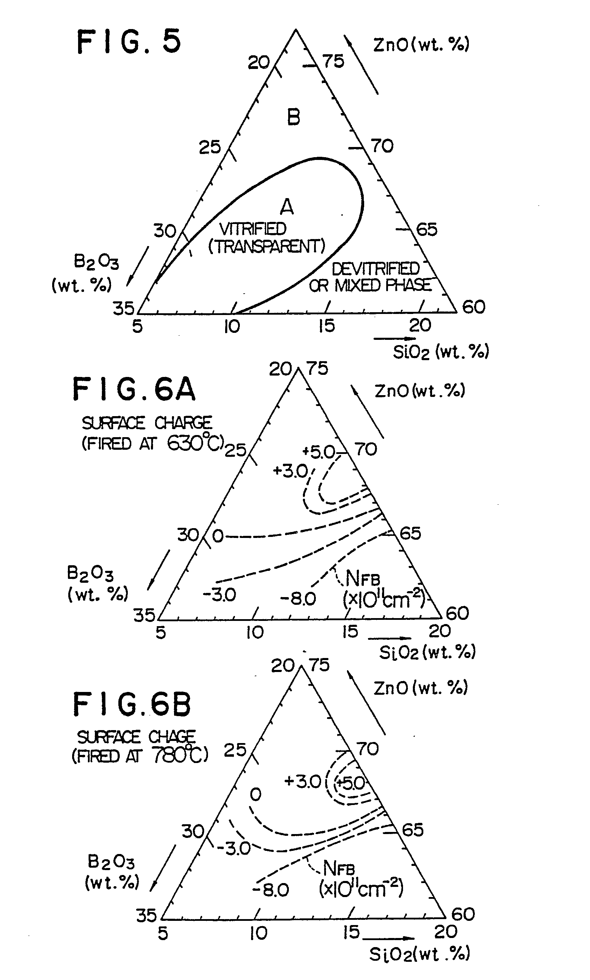

Various materials containing three components ZnO, $B_2O_3$ and $SiO_2$ at different mixing ratios were prepared to find a vitrifiable composition range. The results obtained are shown in Fig. 5. In Fig. 5, a region A indicates a composition range in which transparent glass was formed, and a region B indicates a composition range in which any mixed material was devitrified or divided into a plurality of phases and therefore transparent glass was not obtained.

Next, a glass material having a composition in the vitrifiable range shown in Fig. 5A was fused in a platinum crucible, and then quenched in the pure water to obtain a lump of glass, which was finely pulverized by a ball mill to obtain a glass powder for passivation. Various glass powders having different compositions within the vitrifiable range were prepared. Each of these glass powder materials was fired on a silicon substrate at a temperature in a range from 630°C to 780°C, and the surface charge density $N_{FB}$ was measured. In such a temperature range, glass is readily softened and is not crystallised. Fig. 6A shows equi-$N_{FB}$ curves which were obtained when the glass powder materials were fired at 630°C, Fig. 6B shows equi-$N_{FB}$ curves for a firing temperature of 780°C. As is apparent from Figs. 6A and 6B, the value of $N_{FB}$ varies greatly with the composition, namely, the mixing ratio of the three components, and moves to the negative side as the firing temperature is higher.

A composition range of glass and a range of firing temperature which are preferably applied to the present invention, are known from Figs. 6A and 6B.

When glass is applied on a semiconductor material, it is desirable that the coefficient of thermal expansion of the glass is as close as possible to that of the semiconductor material. When a large number of elements or chips are simultaneously formed in a semiconductor wafer having a large diameter and then are divided into the respective elements, moats as described in the above-mentioned embodiments are distributed almost all over one major surface of the wafer with glass filled therein. In such a case, if the above glass has a greatly different thermal expansion coefficient from that of the semiconductor wafer, the semiconductor wafer may be warped due to the different thermal expansion (contraction) during cooling from the firing temperature to the room temperature. When a photo-etching process is to be carried out for the wafer (for example, when the gate and cathode electrodes are to be formed through the photo-etching process in the above-mentioned embodiments), such a warp may constitute an obstacle to the accurate printing of a predetermined photoresist pattern on the wafer. Further, when the warp of the wafer is large, there is a risk of the wafer and glass being cleaved and/or cracked. In the case of silicon, to avoid such difficulties, it is preferable to set the coefficient of thermal expansion of glass after firing within a range from $25 \times 10^{-7}/°C$ to $50 \times 10^{-7}/°C$.

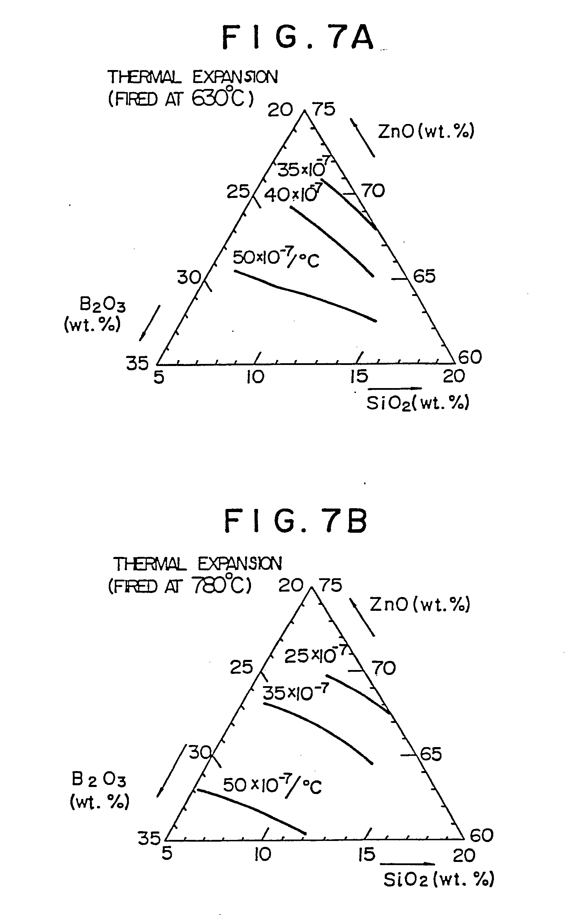

The glass containing three main components ZnO, $B_2O_3$ and $SiO_2$ as described above has the thermal expansion characteristics discussed below. Several glass powder materials having various compositions within the vitrifiable range shown in Fig. 5 were each fired to a thickness of 10 μm on a silicon wafer of 200 to 500 μm thick at a temperature within a range from 630 to 780°C, and the relation between the warp of silicon wafer and the difference in coefficient of thermal expansion between glass and silicon was studied. As a result of the study, it was found that the coefficient of thermal expansion of glass varied greatly with the composition of glass and the firing temperature. Fig. 7A shows equi-thermal-expansion curves in the case where glass powder materials were fired at 630°C, and Fig. 7B shows equi-thermal-expansion curves for a firing temperature of 780°C. As is apparent from the comparison between Figs. 7A and 7B, glass containing a large amount of ZnO has a smaller coefficient of thermal expansion, and the equi-thermal-expansion curves move to a composition region containing a relatively smaller amount of ZnO, as the firing temperature is higher. When glass had a coefficient of thermal expansion of $25 \times 10^{-7}/°C$ to $50 \times 10^{-7}/°C$ after firing, the warp of silicon wafer was small and it was possible to print precisely a photoresist pattern for photo-etching. Moreover, the glass was not cracked. On the other hand, when glass had a coefficient of thermal expansion less than $25 \times 10^{-7}/°C$ or more than $50 \times 10^{-7}/°C$ after firing, the glass might be broken, or the warp of silicon wafer became large and therefore it was difficult to print the photoresist pattern.

A composition range of glass and a range of firing temperature, which are preferable in the present invention, may be determined from Figs. 7A and 7B. Since the above-mentioned glass contains only three main components ZnO, $B_2O_3$ and $SiO_2$, variations in characteristic of glass are limited to a relatively small range. Therefore, when the above glass is used, uniform, reproducible semiconductor elements may be obtained.

While the preferred embodiments have been explained, the present invention is not limited to these embodiments but is applicable to various semiconductor devices. For example, when the p-emitter region 15 in the embodiment shown in Figs. 1A and 1B is replaced by an n-type semiconductor region, a transistor structure is obtained. Such a structure is also within the scope of the present invention. Also, in the embodiment shown in Fig. 4B, the side surface 103 of the semiconductor substrate 1 may be coated with a passivation material such as glass or resin. The materials, fabricating methods and dimensions used in the embodiments may be appropriately altered. The conductivity type of each semiconductor region may be reversed. In this case, glass having positive charges is employed, and a preferable range of surface charge density is $+3 \times 10^{11} cm^{-2}$ to $+9 \times 10^{11} cm^{-2}$.

## Claims

1. A semiconductor device having:

two semiconductor regions (11, 12) of opposite conductivity type in a semiconductor substrate (1), the two semiconductor regions (11, 12) defining a pn junction (J);

a moat (51) in the form of a closed loop in at least one major surface (101) of the substrate (1) such that the pn junction (J) terminates at an inner inclined surface of the moat, a first one (11) of the semiconductor regions extending below the moat (51);

fired glass (21) in the moat (51) for passivating an exposed end portion of the pn junction (J);

a channel stopper region (14) in the substrate (1) adjacent and outside the moat (51), the channel stopper region (14) being of the same conductivity type as the first one (11) of the semiconductor regions but higher in impurity concentration than that region (11); and

at least two electrodes (31, 33) on major surfaces (101, 102) of the substrate (1) for permitting a reverse bias voltage to be applied to the pn junction (J);

characterised in that:

the fired glass (21) has electric charges of a polarity for inducing charges of a polarity opposite to the conductivity type of the first one (11) of the semiconductor regions in a part of that region (11) in contact with the moat (51); and

the depth of the channel stopper region (14) from the major surface (101) of the substrate is greater than the depth of the pn junction (J) from that major surface (101).

2. A semiconductor device according to claim 1, wherein the electric charges of fired glass (21) have a surface density in a range from $3\times10^{11}cm^{-2}$ to $9\times10^{11}cm^{-2}$ when expressed in terms of absolute value.

3. A semiconductor device according to claim 1 or claim 2 wherein the channel stopper region (14) has a width of at least 50 µm in a direction perpendicular to its lengthwise direction.

4. A semiconductor device according to any one of the preceding claims wherein said fired glass (21) contains $ZnO$, $B_2O_3$ and $SiO_2$ as its three main components.

5. A semiconductor device according to any one of the preceding claims wherein the semiconductor substrate (1) has a four-layer laminate structure in which a first emitter layer (13) of a first conductivity type, a first base layer (12) of a second conductivity type, the first base layer being the other one (12) of the semiconductor regions, a second base layer (11) of the first conductivity type having an impurity concentration lower than an impurity concentration in the first base layer (12), the second base layer being the first one (11) of the semiconductor regions and a second emitter layer (15) of the second conductivity type having an impurity concentration higher than an impurity concentration in the second base layer (11) are successively stacked in this order in a direction from one surface (101) to the other surface, and wherein the at least two electrodes include a first main electrode (31) in ohmic contact with the first emitter layer (13) at the surface (101) of the substrate and a second emitter layer (15) at the other surface (102) of the substrate, and the device further comprising a gate electrode (32) in ohmic contact with the first base layer (12) on the surface (101) of the substrate.

6. A semiconductor device according to claim 5, wherein the semiconductor substrate (1) has a second moat (512) at the outside of the channel stopper region (14), and wherein a pn junction ($J_1$) at a boundary between the second base layer (11) and the second emitter layer (15) is bent so as to be directed to the surface (101) of the substrate, and terminates at the second moat (512) so as to form a positive bevel structure.

7. A semiconductor device according to claim 5 or claim 6, wherein a further semiconductor region (161, 162) penetrates the second emitter layer (15) for making an ohmic connection between the second main electrode (33) and the second base layer (11), wherein the further semiconductor region (161, 162) is formed side by side with the second emitter layer (15) so as to be contiguous to the second emitter layer (15), wherein the further semiconductor region (161, 162) has the same conductivity type as the stopper region (14), and has substantially same thickness and impurity concentration as the channel stopper region (14), and wherein the thickness of the further semiconductor region (161, 162) is greater than the depth from the one major surface (101) of the pn junction (J) between the first base layer (12) and the second base layer (11).

**Patentansprüche**

1. Halbleitervorrichtung mit

zwei Halbleiterbereichen (11, 12) entgegengesetzten Leitfähigkeitstyps in einem Halbleitersubstrat (1), die einen pn-Übergang (J) festlegen;

einem Graben (51), der in Form einer geschlossenen Schleife in zumindest einer Hauptoberfläche (101) des Substrats (1) so ausgebildet ist, daß der pn-Übergang (J) an einer inneren geneigten Fläche des Grabens abschließt, wobei ein erster (11) der Halbleiterbereiche unter dem Graben (51) verläuft;

gebranntem Glas (21) in dem Graben (51) für die Passivierung eines freigelegten Endbereiches des pn-Übergangs (J);

einem Kanalstopperbereich (14) in dem Substrat (1) angrenzend an den und außerhalb des Grabens (51), wobei der Kanalstopperbereich (14) denselben Leitfähigkeitstyp wie der erste (11) der Halbleiterbereiche, jedoch eine höhere Dotierstoffkonzentration als dieser Bereich (11) aufweist; und

zumindest zwei Elektroden (31, 33) auf Hauptoberflächen (101, 102) des Substrats (1), die das Anlegen einer Sperr-Vorspannung an den pn-Übergang (J) zulassen;

dadurch gekennzeichnet,

daß das gebrannte Glas (21) elektrische Ladungen einer Polarität aufweist, um Ladungen einer Polarität entgegengesetzt zum Leitfähigkeitstyp des ersten (11) der Halbleiterbereiche in einem Teil dieses Bereiches (11) in Kontakt mit dem Graben (51) zu induzieren; und

daß die Tiefe des Kanalstopperbereichs (14) von der Hauptoberfläche (101) des Substrats größer als die Tiefe des pn-Übergangs (J) von dieser Hauptoberfläche (101) ist.

2. Halbleitervorrichtung nach Anspruch 1, wobei die elektrischen Ladungen des gebrannten Glases (21) eine Oberflächendichte in einem Bereich von $3\times10^{11}cm^{-2}$ bis $9\times10^{11}cm^{-2}$, ausgedrückt in Absolutwerten, haben.

3. Halbleitervorrichtung nach Anspruch 1 oder Anspruch 2, wobei der Kanalstopperbereich (14) eine Breite von zumindest 50 µm in einer Richtung senkrecht zu seiner Längsrichtung hat.

4. Halbleitervorrichtung nach einem der vorhergehenden Ansprüche, wobei das gebrannte Glas

(21) ZnO, $B_2O_3$ und $SiO_2$ als seine drei Hauptkomponenten enthält.

5. Halbleitervorrichtung nach einem der vorhergehenden Ansprüche, wobei das Halbleitersubstrat (1) eine laminierte Struktur aus vier Schichten aufweist, in der eine erste Emitterschicht (13) eines ersten Leitfähigkeitstyps, eine erste Basisschicht (12) eines zweiten Leitfähigkeitstyps, die der zweite Bereich (12) der Halbleiterbereiche ist, eine zweite Basisschicht (11) des ersten Leitfähigkeitstyps, die der erste Bereich (11) der Halbleiterbereiche ist und eine Dotierstoffkonzentration niedriger als eine Dotierstoffkonzentration in der ersten Basisschicht (12) aufweist, und eine zweite Emitterschicht (15) des zweiten Leitfähigkeitstyps, die eine Dotierstoffkonzentration höher als eine Dotierstoffkonzentration in der zweiten Basisschicht (11) aufweist, in dieser Reihenfolge in Richtung von einer Oberfläche (101) zu der anderen Oberfläche übereinandergeschichtet sind, und wobei die zumindest zwei Elektroden eine erste Hauptelektrode (31) in Ohm'schem Kontakt mit der ersten Emitterschicht (13) auf der Oberfläche (101) des Substrats und eine zweite Hauptelektrode (33) in Ohm'schem Kontakt mit der zweiten Emitterschicht (15) auf der anderen Oberfläche (102) des Substrats umfassen, und wobei die Vorrichtung weiterhin eine Gate-Elektrode (32) in Ohm'schem Kontakt mit der ersten Basisschicht (12) auf der Oberfläche (101) des Substrats aufweist.

6. Halbleitervorrichtung nach Anspruch 5, wobei das Halbleitersubstrat (1) einen zweiten Graben (512) auf der Außenseite des Kanalstopperbereichs (14) hat, und wobei ein pn-Übergang ($J_1$) an einer Grenze zwischen der zweiten Basisschicht (11) und der zweiten Emitterschicht (15) so gekrümmt ist, daß er zur Oberfläche (101) des Substrats gerichtet ist, und an dem zweiten Graben (512) so abschließt, daß er eine positiv abgeschrägte Struktur bildet.

7. Halbleitervorrichtung nach Anspruch 5 oder Anspruch 6, wobei ein weiterer Halbleiterbereich (161, 162) die zweite Emitterschicht (15) durchdringt, um eine Ohm'sche Verbindung zwischen der zweiten Hauptelektrode (33) und der zweiten Basisschicht (11) herzustellen, wobei der weitere Halbleiterbereich (161, 162) seitlich neben der zweiten Emitterschicht (15) so gebildet ist, daß er an die zweite Emitterschicht (15) anstößt, wobei der weitere Halbleiterbereich (161, 162) denselben Leitfähigkeitstyp wie der Stopperbereich (14) und im wesentlichen dieselbe Dicke und Dotierstoffkonzentration wie der Kanalstopperbereich (14) aufweist, und wobei die Dicke des weiteren Halbleiterbereichs (161, 162) größer als die Tiefe des pn-Übergangs (J) zwischen der ersten Basisschicht (12) und der zweiten Basisschicht (11) von der einen Hauptoberfläche (101) ist.

**Revendications**

1. Dispositif à semiconducteurs comportant:
— deux régions semiconductrices (11, 12) possédant des types de conductivité opposés et ménagées dans un substrat semiconducteur (1), les deux régions semiconductrices (11, 12) définissant une jonction pn (J);
— un sillon (51) réalisé sous la forme d'une boucle fermée dans au moins une surface principale (101) du substrat (1) de telle sorte que la jonction pn (J) se termine au niveau d'une surface intérieure inclinée du sillon, une première (11) des régions semiconductrices s'étendant au-dessous du sillon (52);
— un verre cuit (21) disposé dans le sillon (51) et servant à passiver une partie d'extrémité exposée de la jonction pn (J);
— une région (14) formant dispositif d'arrêt de canal, ménagée dans le substrat (1) au voisinage et à l'extérieur du sillon (51), la région (14) formant dispositif d'arrêt de canal possédant le même type de conductivité que la première (11) des régions semiconductrices, mais possédant une concentration en impuretés plus élevée que la première région (11); et
— au moins deux électrodes (31, 33) situées sur des surfaces principales (101, 102) du substrat (1) servant à permettre l'application d'une tension de polarisation en inverse à la jonction pn (J);
caractérisé en ce que:
— le verre cuit (21) comporte des charges électriques possédant une polarité servant à induire des charges d'une polarité opposée au type de conductivité de la première (11) des régions semiconductrices dans une partie de cette région (11), qui est en contact avec le sillon (51); et
— la profondeur de la région (14) formant dispositif d'arrêt de canal, à partir de la surface principale (101) du substrat, est supérieure à la profondeur de la jonction pn (J) s'étendant à partir de cette surface principale (101).

2. Dispositif à semiconducteurs selon la revendication 1, dans lequel les charges électriques du circuit (21) possèdent une densité superficielle se situant dans une gamme comprise entre $3 \times 10^{11} cm^{-2}$ et $9 \times 10^{11} cm^{-2}$, exprimée sous la forme d'une valeur absolue.

3. Dispositif à semiconducteurs selon la revendication 1 ou 2, dans lequel la région (14) formant dispositif d'arrêt de canal possède une largeur égale à au moins 50 µm suivant une direction perpendiculaire à sa direction longitudinale.

4. Dispositif à semiconducteurs selon l'une quelconque des revendications précédentes, dans lequel ledit verre cuit (21) contient trois composants principaux qui sont le ZnO, le $B_2O_3$ et le $SiO_2$.

5. Dispositif à semiconducteurs selon l'une quelconque des revendications précédentes, dans lequel le substrat semiconducteur (1) comporte une structure stratifiée à quatre couches, dans la première une première couche d'émetteur (13) possédant un premier type de conductivité, une première couche de base (12) possédant un second type de conductivité et constituant l'autre (12) des régions semiconductrices, une seconde couche de base (11) possédant le premier type de conductivitè et une concentration en impuretés inférieure à la concentration en impuretés de la première couche de base (12) et constituant la première (11) des couches semiconductrices, et une seconde couche d'émetteur (15) possédant le second type de conductivité et une concentration en impuretés supérieure à la concentration en impuretés présente dans la seconde couche de base (11), sont empilées successivement dans cet ordre suivant une direction s'étendant depuis la surface (101) en direction de l'autre surface, et dans lequel lesdites deux électrodes incluent une première électrode principale (31) qui est en contact ohmique avec la première couche d'émetteur (13) au niveau de la surface (1) du substrat, et une seconde électrode principale (33) qui est en contact ohmique avec la seconde couche d'émetteur (15) au niveau de l'autre surface (102) du substrat, et le dispositif comportant en outre une électrode de grille (32) qui est en contact ionique avec la première couche de base (12) située sur la surface (101) du substrat.

6. Dispositif à semiconducteurs selon la revendication 5, dans lequel le substrat semiconducteur (1) comporte un second sillon (72) ménagé sur la face extérieure de la région (14) formant dispositif d'arrêt de canal, et dans lequel une jonction pn (J₁) située au niveau de la limite entre la seconde couche de base (11) et la seconde couche d'émetteur (15) est coudée de manière à être dirigée en direction de la surface (101) du substrat, et se termine au niveau du second sillon (72) de manière à former une structure en biseau positif.

7. Dispositif à semiconducteurs selon la revendication 5 ou 6, dans lequel une autre région semiconductrice (161, 162) pénètre dans le seconde couche d'émetteur (15) de manière à établir un contact ohmique entre la seconde électrode principale (33) et la seconde couche de base (1 ou 11), et dans lequel l'autre région semiconductrice (161, 162) est disposée côte-à-côte avec la seconde couche d'émetteur (15) de manière à être contiguë à cette seconde couche d'émetteur (15), et dans lequel l'autre région semiconductrice (161, 162) possède le même type de conductivité que la région (14) formant dispositif d'arrêt et possède essentiellement la même épaisseur et la même concentration en impuretés que la région (14) formant dispositif d'arrêt de canal, et dans lequel l'épaisseur de l'autre région semiconductrice (161, 162) est supérieure à la profondeur de la jonction pn (J) entre la première couche de base (12) et la seconde couche de base (11), par rapport à une surface principale (101).

# FIG. IA

# FIG. IB

# FIG. 2

# F I G. 3A

# F I G. 3B

# FIG. 4A

# FIG. 4B

FIG. 5

FIG. 6A

SURFACE CHARGE
(FIRED AT 630°C)

FIG. 6B

SURFACE CHAGE
(FIRED AT 780°C)

## F I G . 7A

THERMAL EXPANSION
(FIRED AT 630°C)

ZnO(wt.%)

$35 \times 10^{-7}$

$40 \times 10^{-7}$

$50 \times 10^{-7}/°C$

$B_2O_3$
(wt.%)

$SiO_2$(wt.%)

## F I G . 7B

THERMAL EXPANSION
(FIRED AT 780°C)

ZnO(wt.%)

$25 \times 10^{-7}$

$35 \times 10^{-7}$

$50 \times 10^{-7}/°C$

$B_2O_3$
(wt.%)

$SiO_2$(wt.%)